# EUROPEAN PATENT SPECIFICATION

(11) **EP 2 455 958 B1**
(45) Date of publication and mention of the grant of the patent: **20.04.2016**
(21) Application number: 10799653.0
(22) Date of filing: 05.02.2010
(51) Int. Cl.: H01H 35/26, H01H 35/38, H03K 17/97, G01L 9/00

(54) **PRESSURE SWITCH**
DRUCKSCHALTER
MANOCONTACTEUR

(30) Priority: 17.07.2009 JP 2009168669
(43) Date of publication of application: 23.05.2012
(73) Proprietor: Koganei Corporation, Koganei-shi Tokyo 184-8533 (JP)
(72) Inventor: YAMAUCHI, Takeshi, Koganei-shi Tokyo 184-8533 (JP)
(74) Representative: Vogel, Andreas
(86) International application number: PCT/JP2010/051714
(87) International publication number: WO 2011/007589

(56) References cited:
- EP-A2- 0 082 064
- DE-B1- 1 940 338
- JP-A- 9 203 677
- JP-A- 10 208 597
- JP-B2- 3 100 331
- JP-U- 57 017 036
- JP-U- H01 122 234

## Description

### TECHNICAL FIELD

The present invention relates to a pressure switch for detecting a fluid pressure by detecting a piston which is driven by a thrust force of fluid against a pressing force.

### BACKGROUND ART

In a fluid pressure circuit for supplying pressure fluid from a fluid pressure source to an actuator such as an air cylinder, a pressure switch is provided, for example, for detecting a fluid pressure in a flow path and performing driving control over the fluid pressure source and a fluid pressure device based on the detection signal. As a pressure switch, for example, a piston-type pressure switch having a piston which is driven by a thrust force of fluid flowing from the flow path is described in Patent Document 1. A spring force in a direction against the thrust force of the fluid is applied to the piston, and an operating pressure value of the pressure switch is set by the spring force. When the piston is driven against this spring force, magnetic field of a permanent magnet mounted on the piston is detected by a magnetic sensor, and the fluid pressure in the flow path corresponding to the operating pressure value is detected.

In such a pressure switch, it is possible to adjust the operating pressure value of the pressure switch by changing the spring force applied to the piston so that the pressure switch can be used for various fluid pressures. A pressing member is accommodated in a case of the pressure switch so as to be movable in a sliding direction of the piston, and a spring member is mounted between the piston and the pressing member. This pressing member is screwed to a screw member rotatably mounted on the case, and the pressing member is moved in the sliding direction of the piston by operating the screw member. In this way, the distance between the piston and the pressing member is changed to change the spring force of the spring member, thereby adjusting the operating pressure value of the pressure switch.

Also, the case is formed with a pressure display wall including a window portion via which a display portion provided to the pressing member is visible from the outside of the case. On the pressure display wall, a scale corresponding to a detectable range of the pressure switch is provided along the window portion, and the operating pressure value is displayed by the scale which is indicated by the position of the display portion when having visual contact with the display portion of the pressing member via the window portion.

### PRIOR ART DOCUMENTS

Patent Document 1: Japanese Patent No. 3100331 B2
Patent Document 2: DE1940338 A1; Patent Document 3: EP0082064 A2

### DISCLOSURE OF THE INVENTION

### PROBLEMS TO BE SOLVED BY THE INVENTION

Meanwhile, in the pressure switch described in Patent Document 1, the screw member is directly screwed to the pressing member. Therefore, the screw member is arranged so that its axial direction is oriented in a sliding direction of the piston, and the screw member is rotatably mounted on a cap which is provided to one end in the sliding direction of the piston in the case. On the other hand, the pressure display wall is formed on a side orthogonal to the sliding direction of the piston in the case so that the display portion moves along the window portion according to the movement of the pressing member. That is, the screw member is mounted on a side orthogonal to the pressure display wall. Therefore, when the screw member is operated by a jig such as slotted screwdriver to adjust the operating pressure value of the pressure switch, it is difficult to operate the screw member while having visual contact with the window portion, and it makes the operation of adjusting the operating pressure value cumbersome and complicated.

Moreover, since the screw member is mounted on a side orthogonal to the pressure display wall, if there is not a sufficient space on the outside of the case on a side where the screw member is mounted, it is difficult to fit the jig in the screw member, thereby making it impossible to perform an operation of adjusting the operating pressure value. Therefore, in this case, it is necessary to secure a sufficient space on the outside of the case on a pressure display wall side to have visual contact with the displayed operating pressure value, and to secure a sufficient space on the outside of the case on a side orthogonal to the pressure display wall, thereby increasing a space in which the pressure switch is installed.

An object of the present invention is to improve operability at the time of adjusting the operating pressure value.

### MEANS FOR SOLVING THE PROBLEMS

The present invention is a pressure switch according to claim 1.

In the pressure switch according to the present invention, the driving-side inclined surface of the adjusting member is formed so as to face in a direction opposite to the pressure display wall, and the adjusting member is moved in a direction away from the pressure display wall, thereby moving the pressing member toward the piston. In the pressure switch according to the present invention, the driving-side inclined surface of the adjusting member is formed so as to face in a direction of the pressure display wall, and the adjusting member is moved in a direction toward the pressure display wall, thereby moving the pressing member toward the piston.

In the pressure switch according to the present invention, on the pressure display wall, a portion where an operating portion of the operating member is provided and a portion where the window portion is provided are on the same plane. In the pressure switch according to the present invention, on the pressure display wall, a portion where an operating portion of the operating member is provided and a portion where the window portion is provided are shifted in a moving direction of the adjusting member.

### EFFECTS OF THE INVENTION

According to the present invention, since an operating member is provided on a pressure display wall provided with a window portion, it is possible to easily adjust an operating pressure value by operating the adjusting member while checking the operating pressure value on the pressure display wall. In this way, it is possible to improve operability at the time of setting the operating pressure value. Also, on the outside of the case on a side orthogonal to the pressure display wall, it is not necessary to secure a sufficient space for allowing an operator to insert a jig for operating the operating member, and therefore it is possible to decrease an installation space including a space for allowing the operator to adjust the pressure switch.

### BRIEF DESCRIPTIONS OF THE DRAWINGS

FIG. 1 is a perspective view showing a pressure switch according to one embodiment of the present invention;
FIG. 2A is a front view of the pressure switch shown in FIG. 1;
FIG. 2B is a cross sectional view of the pressure switch shown in FIG. 1;
FIG. 3 is a cross sectional view showing an operation of the pressure switch;
FIG. 4A is a front view of the pressure switch adjusted in operating pressure value from its state shown in FIG. 2;
FIG. 4B is a cross sectional view of the pressure switch adjusted in operating pressure value from its state shown in FIG. 2;
FIG. 5 is a cross sectional view showing one modification example of the pressure switch shown in FIG. 2;
FIG. 6 is a perspective view showing a pressure switch according to another embodiment of the present invention;
FIG. 7A is a front view of the pressure switch shown in FIG. 6;
FIG. 7B is a cross sectional view of the pressure switch shown in FIG. 6;
FIG. 8A is a front perspective view of a pressure switch according to still another embodiment of the present invention; and
FIG. 8B is a rear perspective view of the pressure switch according to still another embodiment of the present invention.

### BEST MODE FOR CARRYING OUT THE INVENTION

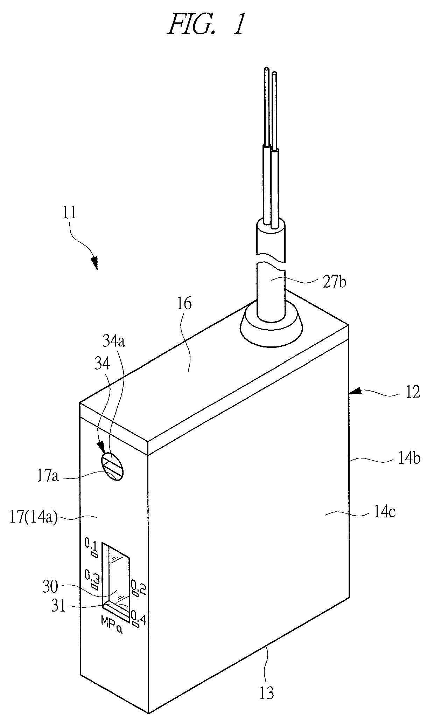

Hereinafter, embodiments of the present invention will be described in detail with reference to the drawings. This pressure switch 11 is provided to a fluid pressure circuit which supplies fluid from a fluid pressure source to a fluid pressure device such as actuator, and is used to detect a fluid pressure in a flow path. As shown in FIG. 1, the pressure switch 11 has a case 12 formed into a rectangular parallelepiped and made of non-magnetic material such as aluminum alloy. The case 12 has a case body and a case cover. The case body is formed of a rectangle bottom wall 13, and a front wall 14a, a back wall 14b, and right and left side walls 14c which are integrally formed with the bottom wall 13. The case cover serves as a blocking wall 16 which blocks an opening of the case body. The pressure switch 11 is arranged so as to direct the bottom wall 13 toward the flow path of the fluid pressure circuit, and is mounted on the fluid pressure circuit via a mounting member (not shown) or the like. The front wall 14a of this case 12 is a pressure display wall 17.

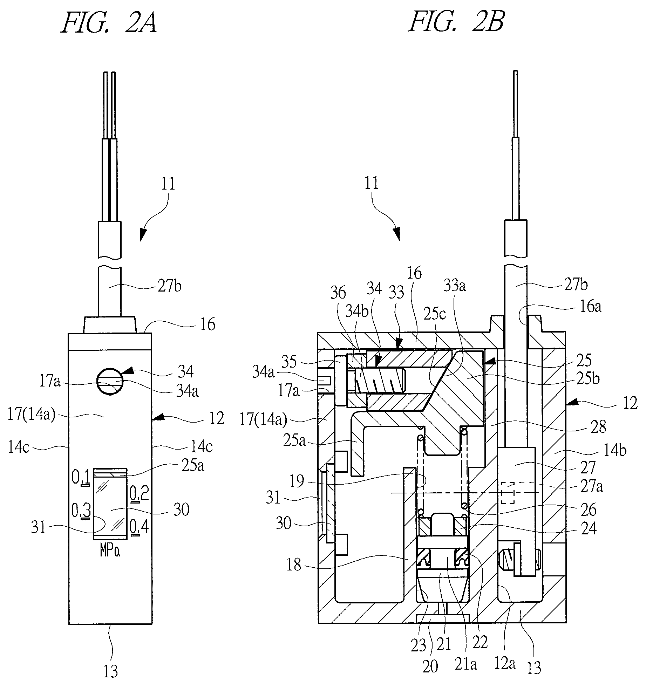

As shown in FIG. 2B, in the case 12, a cylindrical cylinder wall 18 integrally formed with the bottom wall 13 extends to an approximately center position in a longitudinal direction of the pressure display wall 17 toward the blocking wall 16. A cylinder hole 19 which opens toward the blocking wall 16 is formed on the inside of the cylinder wall 18 and adapted to communicate with the flow path of the fluid pressure circuit via a communication port 20 formed on the bottom wall 13.

A piston 21 is accommodated in the cylinder hole 19 so as to be movable in an axial direction of the cylinder hole 19. A piston seal 22 which slidably makes contact with the inner surface of the cylinder hole 19 is attached to an annular groove 21a formed in the piston 21, and a pressure chamber 23 is hermetically formed by the piston 21 on the bottom wall 13 side of the cylinder hole 19. The pressure chamber 23 communicates with the flow path via the communication port 20 and a thrust force is applied to the piston 21 in the direction of the blocking wall 16 by the fluid flowing from the flow path into the pressure chamber 23. Also, a permanent magnet 24 is mounted on the piston 21 as a detected body.

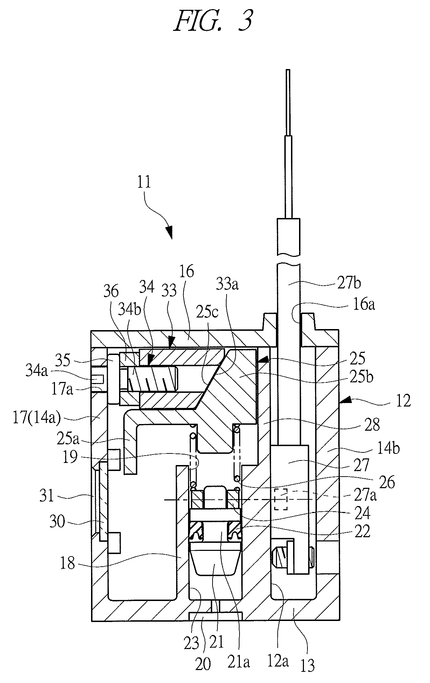

A pressing member 25 is accommodated in the case 12 and closer to the blocking wall 16 than the cylinder wall 18. A coil spring 26 as an elastic member is mounted between the pressing member 25 and the piston 21 so that its axial direction is oriented in a sliding direction of the piston 21, and the piston 21 is pressed by the coil spring 26 toward the pressure chamber 23. That is, a thrust force is applied to the piston 21 by a pressure fluid flowing into the pressure chamber 23 toward the pressing member 25 against a pressing force of the coil spring 26 provided to the pressing member 25. When the thrust force is not applied to the piston 21 by the pressure fluid, the piston 21 is moved by the pressing force of the coil spring 26 toward the pressure chamber 23 to take a forward limit position shown in FIG. 2B. On the other hand, when the thrust force applied to the piston 21 by the pressure fluid becomes equal to an operating pressure value set by the pressing force of the coil spring 26, the piston 21 is moved toward the pressing member 25 against the pressing force of the coil spring 26 to take a pressure detection position shown in FIG. 3. In this way, a pressure of the fluid in the pressure chamber 23 corresponding to a state where the piston 21 takes the pressure detection position, that is, the operating pressure value of the pressure switch 11 is set by the pressing force of the coil spring 26 to the piston 21.

To detect whether or not the piston 21 is in the pressure detection position by the position of the permanent magnet 24 provided to the piston 21, a magnetic sensor 27 for detecting a magnetic field of the permanent magnet 24 mounted on the piston 21 is incorporated in the case 12. As the magnetic sensor 27, for example, an MR element (magnetoresistive element) or Hall element is used, thereby detecting that the permanent magnet 24 mounted on the piston 21 approaches the magnetic sensor 27. The magnetic sensor 27 is accommodated in a sensor accommodation chamber 12a formed by a partition wall 28 integrally formed with the cylinder wall 18 on the back wall 14b side in the case 12. A sensor element 27a of this magnetic sensor 27 is arranged adjacent to the pressing member 25 side of the cylinder wall 18 so as to correspond to the pressure detection position of the piston 21. Also, the magnetic sensor 27 is connected to a control device of the fluid pressure circuit via a cable 27b which extends to the outside of the case 12 via a through hole 16a of the blocking wall 16. With the magnetic field of the permanent magnet 24 mounted on the piston 21 being detected by the magnetic sensor 27, the pressure in the pressure chamber 23 moves the piston 21 back toward the pressing member 25 against the pressing force of the coil spring 26, and it is detected that the piston 21 is in the pressure detection position. In this way, it is detected by the pressure switch 11 that the pressure in the pressure chamber 23 becomes equal to the preset operating pressure value set by the pressing force of the coil spring 26 and, based on a signal indicative of the detection, driving control over a fluid pressure source and a fluid pressure device is performed.

In addition, in this embodiment, the sensor element 27a of the magnetic sensor 27 is arranged so as to correspond to the pressure detection position of the piston 21 and it is detected that the piston 21 is in the pressure detection position when the output of the magnetic sensor 27 is switched from an OFF state to an ON state. However, the present invention is not limited to this configuration. For example, the sensor element 27a of the magnetic sensor 27 may be arranged so as to correspond to the forward limit position of the piston 21 and, with an output of the magnetic sensor 27 being switched from an OFF state to an ON state, it may be detected that the piston 21 is in the pressure detection position. That is, in this case, by the pressure in the pressure chamber 23, the piston 21 is moved back toward the pressing member 25 against the pressing force of the coil spring 26, the permanent magnet 24 mounted on the piston 21 goes away from the magnetic sensor 27, and the magnetic field of the permanent magnet 24 ceases to be detected by the magnetic sensor 27. In this way, it is detected that the piston 21 is in the pressure detection position.

In this pressure switch 11, the operating pressure value which is set by the pressing force of the coil spring 26 can be adjusted so that the pressure switch 11 can be used in various fluid pressure circuits different from each other in working pressure value of the fluid pressure device. The pressing member 25 faces the piston 21 and accommodated in the case 12 so as to be movable in a sliding direction of the piston 21. It is possible to change the pressing force of the coil spring 26 to be applied to the piston 21 in the direction of the pressure chamber 23 by shifting the pressing member 25 in the sliding direction of the piston 21 to change the distance between the pressing member 25 and the piston 21. In this way, the operating pressure value of the pressure switch 11 set by the pressing force of the coil spring 26 is adjusted. For example, since, when the pressing member 25 is moved toward the piston 21, the distance between the pressing member 25 and the piston 21 is decreased and the pressing force of the coil spring 26 to be applied to the piston 21 to the pressure chamber 23 side is increased, the operating pressure value of the pressure switch 11 is increased. Conversely, since, when the pressing member 25 is moved toward the blocking wall 16, the distance between the pressing member 25 and the piston 21 is increased, and the pressing force of the coil spring 26 to be applied to the piston 21 to the pressure chamber 23 side is decreased, the operating pressure value of the pressure switch 11 is decreased.

The pressing member 25 includes a display portion 25a formed by bending it toward the bottom wall 13 from the pressure display wall 17 side end portion. The display portion 25a is located near the pressure display wall 17, extends in the longitudinal direction of the pressure display wall 17, and is configured to move with the pressing member 25 in the sliding direction of the piston 21, that is, the longitudinal direction of the pressure display wall 17. This display portion 25a has a surface colored in red, blue, or the like on the pressure display wall 17 side. Also, a pressed portion 25b provided to the blocking wall 16 side of the pressing member 25 is formed with a driven-side inclined surface 25c which faces the pressure display wall 17 side and which is inclined toward the pressure display wall 17 while extending toward the piston 21.

On the other hand, as shown in FIG. 2A, the pressure display wall 17 is formed with a window portion 31 which is formed in a longitudinal direction of the pressure display wall 17 and to which a transparent cover 30 is attached so that it is possible to have visual contact with the inside of the case 12 via the transparent cover 30. Calibration markings are provided on the pressure display wall 17 along the window portion 31 according to a detectable range of the pressure switch 11, that is, a settable range of the operating pressure value. As shown in figures, a scale of 0.1 (MPa) to 0.4 (MPa) at intervals of 0.1 is provided in the shown pressure switch so that the numerical value in the scale increases from the blocking wall 16 side toward the bottom wall 13 side. When having visual contact with the display portion 25a of the pressing member 25 via this window portion 31, the operating pressure value of the pressure switch 11 is externally displayed by a scale which is indicated by the position of the bottom wall 13 side end face of the display portion 25a. Additionally, it is possible to arbitrarily set the settable range of the operating pressure value of the pressure switch 11 by, for example, replacing the coil spring to the one with a different spring constant.

In order to adjust the operating pressure value of the pressure switch 11 by moving the pressing member 25 in the sliding direction of the piston 21, a cylindrical adjusting member 33 is accommodated in the case 12. The adjusting member 33 is located close to the pressure display wall 17 with respect to the pressed portion 25b of the pressing member 25 and disposed so as to be movable in a direction orthogonal to the sliding direction of the piston 21, that is, a direction toward or away from the pressure display wall 17. A driving-side inclined surface 33a which slidably makes contact with the driven-side inclined surface 25c of the pressing member 25 is formed on an end face of the back wall 14b side of the adjusting member 33 and inclined toward the pressure display wall 17 side while extending toward the piston 21. When this adjusting member 33 is moved in a direction away from the pressure display wall 17, a pushing force is applied via the inclined surfaces 25c and 33a from the adjusting member 33 to the pressing member 25 in the direction of the piston 21 and the pressing member 25 is moved toward the piston 21 against the pressing force of the coil spring 26. Conversely, when the adjusting member 33 is moved in the direction toward the pressure display wall 17, the pushing force to be applied via the inclined surfaces 25c and 33a from the adjusting member 33 to the pressing member 25 is decreased and the pressing member 25 is moved toward the blocking wall 16 by the pressing force of the coil spring 26.

A screw member 34 as an operating member for moving the adjusting member 33 to set the pressing force of the coil spring 26 so that the piston 21 takes the pressure detection position is provided on the blocking wall 16 side of the pressure display wall 17. The screw member 34 is disposed on the same axis as that of the adjusting member 33, and is rotatably supported by a fixing member 35 integrally formed with a screw member 34 and abutting on an inner surface of the pressure display wall 17. A head portion 34a of this screw member 34 is inserted in a through hole 17a formed in the pressure display wall 17, and as shown in FIG. 2A, it is exposed on the outside of the case 12 on the same side of the window portion 31. That is, on the pressure display wall 17, a portion where the head portion 34a of the screw member 34 is provided and a portion where the window portion 31 is provided are formed on the same plane. Also, a nut member 36 is screwed to a male thread portion 34b of the screw member 34. The male thread part 34b of the screw member 34 is rotatably and movably inserted in the adjusting member 33, and in this condition, the cylindrical adjusting member 33 abuts on a back wall 14b side end face of the nut member 36. By fitting a jig such as a slotted screwdriver in the head portion 34a of this screw member 34 and rotating the screw member 34, the adjusting member 33 is moved together with the nut member 36 in an axial direction of the screw member 34, that is, a direction orthogonal to the sliding direction of the piston 21. In this way, the operating pressure value of the pressure switch 11 is adjusted.

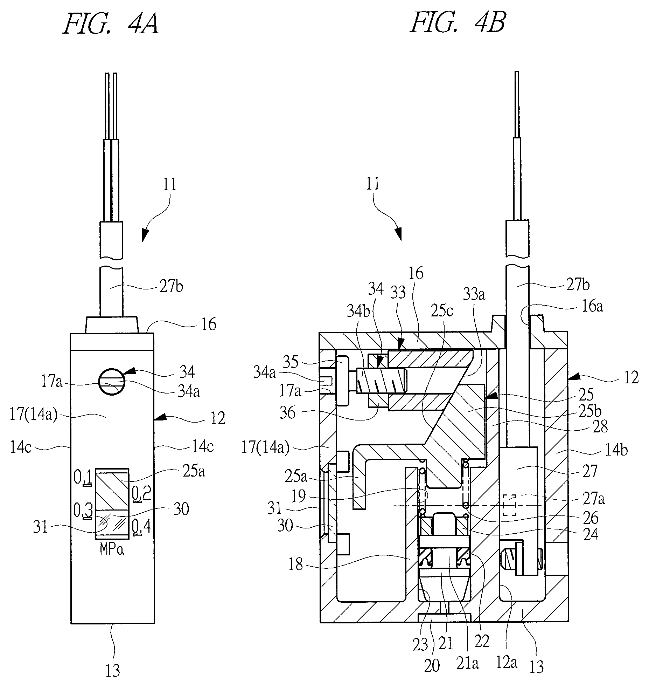

When the operating pressure value of the pressure switch 11 is adjusted, while having visual contact with the display portion 25a of the pressing member 25 via the window portion 31 of the pressure display wall 17 to check the operating pressure value of the pressure switch 11, the jig is fitted in the head portion 34a of the screw member 34 to perform an operation of rotating the screw member 34. For example, when the operating pressure value of the pressure switch 11 is set to 0.25 MPa, as shown in FIG. 4A and FIG. 4B, the screw member 34 is rotated in a counterclockwise direction to move the adjusting member 33 together with the nut member 36 in a direction away from the pressure display wall 17 and to press the pressing member 25 via the inclined surfaces 25c and 33a toward the piston 21. In this way, the pressing force of the coil spring 26 to be applied to the piston 21 toward the pressure chamber 23 is increased and the operating pressure value of the pressure switch 11 is adjusted to be increased. Here, as the pressing member 25 is moved toward the piston 21, the display portion 25a of the pressing member 25 moves along the window portion 31 toward the bottom wall 13. By performing an operation of rotating the screw portion 34 until the scale indicates 0.25 MPa by the position of the end face of this display portion 25a on the bottom wall 13 side, the operating pressure value of the pressure switch 11 can be set at 0.25 MPa. Conversely, by performing an operation of rotating the screw member 34 in a clockwise direction, the adjusting member 33 is moved in a direction toward the pressure display wall 17, and the operating pressure value of the pressure switch 11 is adjusted to be decreased.

As described above, since the screw member 34 for adjusting the operating pressure value is mounted on the pressure display wall 17 for displaying the operating pressure value of the pressure switch 11, it is possible to easily perform an operation of rotating the screw member 34 to adjust the operating pressure value of the pressure switch 11 while having visual contact with the display portion 25a of the pressing member 25 via the window portion 31 of the pressure display wall 17 to check the operating pressure value of the pressure switch 11. In this way, it is possible to improve operability at the time of adjusting the operating pressure value. Also, in conventional technologies, when the screw member is mounted on a cap provided on a side orthogonal to the pressure display wall, a sufficient space is required on the outside of the case on the pressure display wall side in order to allow the display of the operating pressure value to be viewable and a sufficient space is required on the outside of the case on a cap side in order to insert the jig in the screw member. By contrast, in the present invention, since the head portion 34a of the screw member 34 is provided to the pressure display wall 17, it is not necessary to secure a sufficient space on the outside of the case 12 on the blocking wall 16 side, and therefore an installation space of the pressure switch 11 can be decreased.

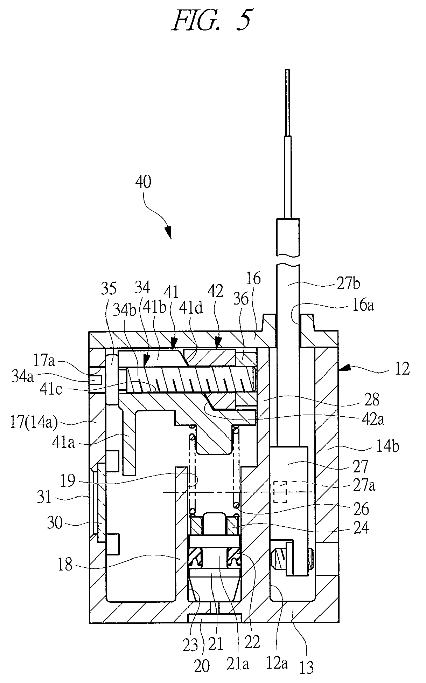

As described above, in the above pressure switch 11, the driving-side inclined surface 33a of the adjusting member 33 is formed to face in a direction opposite to the pressure display wall 17 and the adjusting member 33 is moved in a direction away from the pressure display wall 17, thereby moving the pressing member 25 toward the piston 21. However, the present invention is not limited to this configuration. Here, FIG. 5 is a cross sectional view showing a modification example of the pressure switch shown in FIGS. 2A and 2B, and in FIG. 5, members the same as those shown in FIGS. 2A and 2B are denoted by the same reference numbers and the detail descriptions thereof are omitted here.

A pressure switch 40 shown in FIG. 5 is a piston-type pressure switch which detects a fluid pressure in a flow path by detecting the position of the piston 21 driven by thrust force of a pressure fluid against the pressing force of the coil spring 26. A pressing member 41 is accommodated in the case 12 so as to be movable in the sliding direction of the piston 21, and the pressing member 41 includes a coil spring 26 for pressing the piston 21 toward the pressure chamber 23. The operating pressure value of the pressure switch 40 is adjusted by moving the pressing member 41 in the sliding direction of the piston 21. Also, the pressing member 41 includes a display portion 41a formed by extending toward the bottom wall 13 from the pressure display wall 17 side end portion. The operating pressure value of the pressure switch 40 is displayed outwardly by a scale which is indicated by the position of the bottom wall 13 side end face of the display portion 41a when having visual contact with this display portion 41a via the window portion 31.

A pressed portion 41b provided to the blocking wall 16 side of the pressing member 41 is formed with a notch 41c opening toward the blocking wall 16. The pressing member 41 and the screw member 34 are prevented from interfering with each other at the time of moving the pressing member 41 by inserting a base end side of the male thread portion 34b of the screw member 34 in the notch 41c. Also, a pressed portion 41b of the pressing member 41 is formed with a driven-side inclined surface 41d which is faced toward the back wall 14b and which is inclined toward the back wall 14b while extending toward the piston 21.

On the other hand, an adjusting member 42 is adjacent to the back wall 14b side with respect to the pressed portion 41b of the pressing member 41, and is disposed so as to freely move in a direction orthogonal to the sliding direction of the piston 21, that is, a direction toward or away from the pressure display wall 17. On an end face of the adjusting member 42 on the pressure display wall 17 side, a driving-side inclined surface 42a slidably making contact with the driven-side inclined surface 41d of the pressing member 41 is formed so as to be inclined to the back wall 14b side toward the piston 21 side. When this adjusting member 42 is moved in a direction toward the pressure display wall 17, a pushing force is applied via the inclined surfaces 41d and 42a from the adjusting member 42 to the pressing member 41 toward a piston 21 side, and the pressing member 41 is moved toward the piston 21 against the pressing force of the coil spring 26. Conversely, when the adjusting member 42 is moved in a direction away from the pressure display wall 17, the pushing force to be applied via the inclined surfaces 41d and 42a from the adjusting member 42 to the pressing member 41 is decreased, and the pressing member 41 is moved toward the blocking wall 16 side by the pressing force of the coil spring 26.

The cylindrical adjusting member 42 abuts on the pressure display wall 17 side end face of the nut member 36 in which a tip of the male thread portion 34b is screwed, under a state where the male thread portion 34b of the screw member 34 is movably inserted in the adjusting member 42. By fitting a jig such as a slotted screwdriver in the head portion 34a of this screw member 34 and performing an operation of rotating the screw member 34, the adjusting member 42 is moved together with the nut member 36 in a direction orthogonal to the sliding direction of the piston 21. In this way, the operating pressure value of the pressure switch 40 is adjusted.

As described above, in the pressure switch 40, the driving-side inclined surface 42a of the adjusting member 42 is formed so as to be faced toward the pressure display wall 17, and the adjusting member 42 is moved in a direction toward the pressure display wall 17, thereby moving the pressing member 41 toward the piston 21. Also, it goes without saying that, in this pressure switch 60, effects similar to those in the pressure switch 11 described above can be obtained.

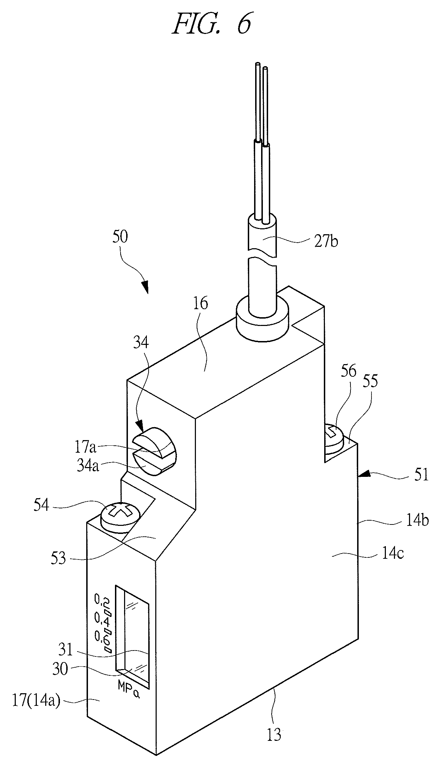

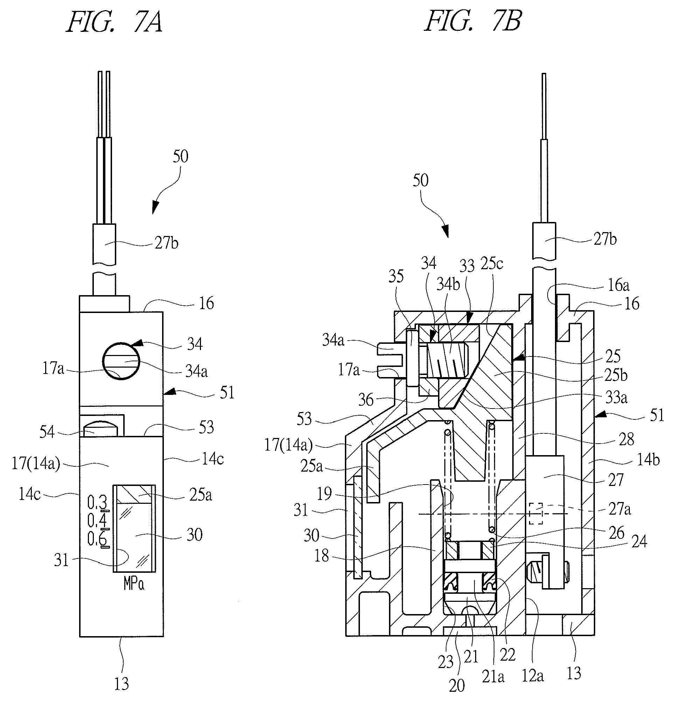

Also, in the pressure switches 11 and 40 described above, on the pressure display wall 17, a portion where the head portion 34a of the screw member 34 is provided and a portion where the window portion 31 is provided are formed on the same plane, thereby causing the head portion 34a of the screw member 34 and the window portion 31 to face on the same side. However, the present invention is not limited to this configuration. Here, FIG. 6 is a perspective view showing a pressure switch according to another embodiment of the present invention, FIG. 7A is a front view of the pressure switch shown in FIG. 6, and FIG. 7B is a cross sectional view of the pressure switch shown in FIG. 6. Additionally, the same members as those shown in FIGS. 1 and 2 are denoted by the same reference numbers as those shown in FIGS. 1 and 2 and the detail descriptions thereof are omitted here.

A pressure switch 50 shown in FIG. 6 has an internal structure approximately similar to that of the pressure switch 11 shown in FIG. 2A and FIG. 2B, and is a piston-type pressure switch which detects a fluid pressure in a flow path by detecting the position of the piston 21 driven by the thrust force of the pressure fluid against the pressing force of the coil spring 26. In this pressure switch 50, a case 51 formed into a substantially rectangular parallelepiped and made of non-magnetic material such as aluminum alloy has a stepped shape partially notched on the blocking wall 16 side, and on the pressure display wall 17 formed of the front wall 14a, the window portion 31 is provided to the bottom wall 13 side and the screw member 34 is provided to the blocking wall 16 side. On the pressure display wall 17, a portion where the head portion 34a of the screw member 34 is provided is shifted toward the back wall 14b side with respect to a portion where the window portion 31 is provided, and these portions are shifted with respect to each other in a moving direction of the adjusting member 33 and are formed so as to face the same side.

On a stepped portion 53 of the pressure display wall 17, a mounting screw 54 is provided at a position corresponding to one of four corners of the bottom wall 13 and faced toward the bottom wall 13. Also, to the back wall 14b in the case 51, a stepped portion 55 is formed at a diagonal position with respect to the mounting screw 54, and a mounting screw 56 is provided to the stepped portion 55 and faced toward the bottom wall 13. With these mounting screws 54 and 56, the pressure switch 50 is mounted on the fluid pressure circuit under a state where the bottom wall 13 is faced toward the flow path of the fluid pressure circuit. However, the display portion 25a of the pressing member 25, the window portion 31, and the magnetic sensor 27 are provided as being shifted to the other diagonal position side on the bottom wall 13 so as not to interfere with the mounting screws 54 and 56.

As described above, in the pressure switch 50, on the pressure display wall 17, a portion where the head portion 34a of the screw member 34 is provided and a portion where the window portion 31 is provided are formed as being shifted in the moving direction of the adjusting member 33, thereby causing the head portion 34a of the screw member 34 and the window portion 31 to face on the same side. It goes without saying that, also in this pressure switch 50, effects similar to those in the pressure switch 11 described above can be obtained. Also, in the pressure switch 50 of the present embodiment, since the stepped portions 53 and 55 are respectively provided on the pressure display wall 17 and the back wall 14b, by the mounting screws 54 and 56 which are fastened to the stepped portions 53 and 55, the pressure switch 50 can be directly fixed to the fluid pressure circuit without a mounting member or the like. In this way, operability at the time of fixing the pressure switch 50 to the fluid pressure circuit is improved. Additionally, note that while the shown pressure switch 50 has an internal structure approximately similar to that of the pressure switch 11, the pressure switch 50 may have an internal structure similar to that of the pressure switch 40.

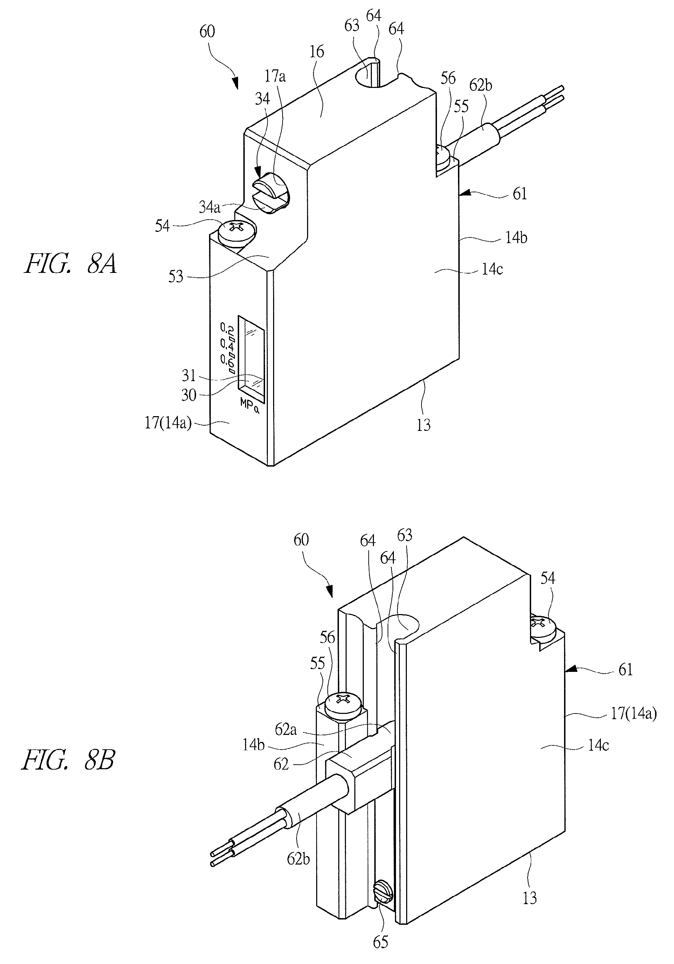

Also, in the pressure switches 11, 40, and 50 described above, the magnetic sensor 27 for detecting the magnetic field of the permanent magnet 24 mounted on the piston 21 is incorporated in each of the cases 12 and 51. However, the present invention is not limited to this configuration. Here, FIG. 8A is a front perspective view of a pressure switch according to still another embodiment of the present invention and FIG. 8B is a rear perspective view of the pressure switch according to still another embodiment of the present invention, and in FIGS. 8A and 8B, the same members as those shown in FIG. 6 are denoted by the same reference numbers and the detail descriptions thereof are omitted here.

A pressure switch 60 shown in FIGS. 8A and 8B has an internal structure similar to that of the pressure switch 11 shown in FIGS. 2A and 2B or that of the pressure switch 40 shown in FIG. 5, and is a piston-type pressure switch which detects a fluid pressure in a flow path by detecting the position of the piston 21 driven by the thrust force of the pressure fluid against the pressing force of the coil spring 26. In this pressure switch 60, as with the case 51 of the pressure switch 50 shown in FIG. 6, a case 61 formed into a substantially rectangular parallelepiped and made of non-magnetic material such as aluminum alloy has a stepped shape partially notched on the blocking wall 16 side, and on the pressure display wall 17, a portion on the blocking wall 16 side where the head portion 34a of the screw member 34 is provided is closer to the back wall 14b side than a portion on the bottom wall 13 side where the window portion 31 is provided.

A sensor accommodation chamber 12a where a magnetic sensor 62 is accommodated is not formed in the case 61 and a sensor groove 63 in which the magnetic sensor 62 is mounted in a detachable manner is formed on the back wall 14b side of the case 61. The sensor groove 63 is formed along the longitudinal direction of the back wall 14b so as not to interfere with the mounting screw 56 and opens at both ends in the longitudinal direction of the sensor groove 63 and on the rear surface of the case 61. In an opening of the sensor groove 63, on a back side, paired fitting projections 64 projecting toward an inner side of the sensor groove 63 in the width direction are integrally provide with the case 61.

On the other hand, the magnetic sensor 62 includes a fitting portion 62a formed into a shape that can fit in the sensor groove 63. The fitting portion 62a of the magnetic sensor 62 is inserted in the sensor groove 63 from the opening at both ends of the sensor groove 63 in the longitudinal direction, a fitting projection 64 preventing it from dropping from the back side opening of the sensor groove 63, and the fitting portion 62a fitting in the sensor groove 63 so as to be movable along the longitudinal direction of the sensor groove 63. Also, correspondingly to the pressure detection position of the piston 21, the magnetic sensor 62 is fixed into the sensor groove 63 with a fixing screw 65 so that a sensor element of the magnetic sensor 62 is adjacent to the pressing member 25 side of the cylinder wall 18. Also, the magnetic sensor 62 is connected to a control device of the fluid pressure circuit with a cable 62b extending to a back side of the case 61.

As described above, in the pressure switch 60, since the magnetic sensor 62 is attached into the sensor groove 63 formed on the outer surface of the case 61, it is possible to easily attach and detach the magnetic sensor 62 in comparison with the case where the magnetic sensor 62 is incorporated in the case 61. Therefore, operability at the time of attaching and detaching the magnetic sensor 62 is improved. Additionally, it goes without saying that, in the pressure switch 60 of this embodiment, effects similar to those in the pressure switch 11 described above can be obtained.

For example, although the scale is provided on the pressure display wall 17 so that the bottom wall 13 side is taken as a lower side in the pressure switches 11, 40, and 50 as shown in the figures, it is possible to arbitrarily define the arrangement of the pressure switches 11, 40, and 50.

### INDUSTRIAL APPLICABILITY

The pressure switch is used to detect that the pressure in the air pressure circuit is a predetermined preset pressure and to control an air-pressure-operated device such as an air cylinder on the basis of its detection signal.

## Claims

1. A pressure switch (11, 40, 50, 60) comprising:
a case (12, 51, 61) provided with a cylinder hole (19) which communicates with a flow path to which a fluid is supplied;
a piston (21) movably accommodated in the cylinder hole, the piston forming a pressure chamber (23) in the cylinder hole and moving back in response to the fluid flowing from the flow path into the pressure chamber;
a magnetic sensor (27, 62) mounted on the case and adapted to detect, according to a position of a permanent magnet (24) provided to the piston, whether or not the piston is in a pressure detection position;
a pressing member (25, 41) facing the piston (21) and accomodated in the case (12, 51, 61) so as to be movable in a sliding direction of the piston (21), the pressing member being adapted to set, on the basis of a pressing force applied to the piston by an elastic member (26) mounted between the pressing member and the piston, a pressure of the fluid in the pressure chamber so that the piston takes the pressure detection position; and
a display portion (25a, 41 a) provided to the pressing member and adapted to display outwardly the set pressure via a window portion (31) provided to a pressure display wall (17) of the case,
**characterized in that** the pressure switch further comprises:
an adjusting member (33, 42) including a driving-side inclined surface (33a, 42a) in sliding contact with a driven-side inclined surface (25c, 41d) formed on the pressing member (25, 41), and the adjusting member is disposed so as to be movable in a direction orthogonal to the sliding direction of the piston; and
an operating member (34) provided to the pressure display wall, the operating member moving the adjusting member to set the pressing force corresponding to a state where the piston takes the pressure detection position, wherein
the operating member is provided to the pressure display wall provided with the window portion.

2. The pressure switch (10, 50) according to claim 1, wherein
the driving-side inclined surface of the adjusting member is formed so as to face in a direction opposite to the pressure display wall, and the adjusting member is movable in a direction away from the pressure display wall, thereby moving the pressing member toward the piston.

3. The pressure switch (40) according to claim 1, wherein
the driving-side inclined surface of the adjusting member is formed so as to face in a direction of the pressure display wall, and the adjusting member is movable in a direction toward the pressure display wall, thereby moving the pressing member toward the piston.

4. The pressure switch (10, 40) according to any one of claims 1 to 3, wherein
on the pressure display wall, a portion where an operating portion of the operating member is provided and a portion where the window portion is provided are on the same plane.

5. The pressure switch (50, 60) according to any one of claims 1 to 3, wherein
on the pressure display wall, a portion where an operating portion of the operating member is provided and a portion where the window portion is provided are shifted in a moving direction of the adjusting member.

## Patentansprüche

1. Druckschalter (11, 40, 50, 60), umfassend:
ein Gehäuse (12, 51, 61), das mit einer Zylinderloch (19) versehen ist, das mit einem Strömungsweg in Verbindung steht, zu welchem Fluid zugeführt wird;
einen Kolben (21), der im Zylinderloch beweglich untergebracht ist, wobei der Kolben eine Druckkammer (23) im Zylinderloch bildet und sich in Reaktion auf Fluid, das vom Strömungsweg in die Druckkammer strömt, zurückbewegt;
einen Magnetsensor (27, 62), der auf dem Gehäuse montiert und so ausgelegt ist, dass er gemäß einer Position eines Dauermagneten (24), der am Kolben vorgesehen ist, erkennt, ob der Kolben in einer Druckerkennungsposition ist oder nicht;
ein Druckelement (25, 41), das dem Kolben (21) zugewandt ist und so im Gehäuse (12, 51, 61) untergebracht ist, dass es in einer Gleitrichtung des Kolbens (21) bewegbar ist, wobei das Druckelement so ausgelegt ist, dass es auf der Basis einer Druckkraft, die durch ein elastisches Element (26), das zwischen dem Druckelement und dem Kolben montiert ist, auf den Kolben ausgeübt wird, einen Druck des Fluids in der Druckkammer so festlegt, dass der Kolben die Druckerkennungsposition einnimmt; und
einen Anzeigeabschnitt (25a, 41a), der am Druckelement vorgesehen und so ausgelegt ist, dass er den festgelegten Druck über einen Fensterabschnitt (31), der in einer Druckanzeigewand (17) des Gehäuses vorgesehen ist, nach außen anzeigt,
**dadurch gekennzeichnet,**
**dass** der Druckschalter ferner umfasst:
ein Einstellelement (33, 42), das eine antriebsseitige geneigte Fläche (33a, 42a) in Gleitkontakt mit einer abtriebsseitigen geneigten Fläche (25c, 41 d) umfasst, die auf dem Druckelement (25, 41) ausgebildet ist, wobei das Einstellelement so angeordnet ist, dass es in eine Richtung orthogonal zur Gleitrichtung des Kolbens bewegt werden kann; und
ein Betätigungselement (34), das an der Druckanzeigewand vorgesehen ist, wobei das Betätigungselement das Einstellelement so bewegt, dass es die Druckkraft entsprechend einem Zustand festlegt, in dem der Kolben die Druckerkennungsposition einnimmt, wobei
das Betätigungselement an der Druckanzeigewand vorgesehen ist, die mit dem Fensterabschnitt versehen ist.

2. Druckschalter (10, 50) nach Anspruch 1, wobei
die antriebsseitige geneigte Fläche des Einstellelements so ausgebildet ist, dass sie in eine Richtung entgegengesetzt zur Druckanzeigewand gerichtet ist, und das Einstellelement in eine Richtung weg von der Druckanzeigewand bewegbar ist, um dadurch das Druckelement zum Kolben zu bewegen.

3. Druckschalter (40) nach Anspruch 1, wobei
die antriebsseitige geneigte Fläche des Einstellelements so ausgebildet ist, dass sie in eine Richtung der Druckanzeigewand gerichtet ist, und das Einstellelement in eine Richtung zur Druckanzeigewand bewegbar ist, um dadurch das Druckelement zum Kolben zu bewegen.

4. Druckschalter (10, 40) nach einem der Ansprüche 1 bis 3, wobei
auf der Druckanzeigewand ein Abschnitt, in dem ein Betätigungsabschnitt des Betätigungselements vorgesehen ist, und ein Abschnitt, in dem der Fensterabschnitt vorgesehen ist, auf der gleichen Ebene sind.

5. Druckschalter (50, 60) nach einem der Ansprüche 1 bis 3, wobei
auf der Druckanzeigewand ein Abschnitt, in dem ein Betätigungsabschnitt des Betätigungselements vorgesehen ist, und ein Abschnitt, in dem der Fensterabschnitt vorgesehen ist, in eine Bewegungsrichtung des Einstellelements verschoben sind.

## Revendications

1. Manocontacteur (11, 40, 50, 60) comprenant :
un boîtier (12, 51, 61) doté d'un trou cylindrique (19) qui communique avec un trajet d'écoulement auquel un fluide est fourni,
un piston (21) reçu de manière mobile dans le trou cylindrique, le piston formant une chambre de pression (23) dans le trou cylindrique et reculant en réponse au fluide circulant du trajet d'écoulement jusque dans la chambre de pression,
un capteur magnétique (27, 62) monté sur le boîtier et destiné à détecter, en fonction d'une position d'un aimant permanent (24) fourni au piston, si le piston est ou non dans une position de détection de pression,
un élément de pression (25, 41) tourné vers le piston (21) et reçu dans le boîtier (12, 51, 61) de manière à être mobile dans une direction de coulissement du piston (21), l'élément de pression étant destiné à régler, sur la base d'une force de pression appliquée au piston par un élément élastique (26) monté entre l'élément de pression et le piston, une pression du fluide dans la chambre de pression de sorte que le piston prenne la position de détection de pression, et
une partie d'affichage (25a, 41a) prévu sur l'élément de pression et destiné à afficher vers l'extérieur la pression réglée par le biais d'une partie de fenêtre (31) prévue sur une paroi d'affichage de pression (17) du boîtier,
**caractérisé en ce que**
le manocontacteur comprend en outre :
un élément d'ajustement (33, 42) incluant une surface inclinée côté entraînement (33a, 42a) en contact glissant avec une surface inclinée côté entraîné (25c, 41 d) formée sur l'élément de pression (25, 41), et l'élément d'ajustement est disposé de manière à être mobile dans une direction orthogonale à la direction de coulissement du piston, et
un élément d'actionnement (34) prévu sur la paroi d'affichage de pression, l'élément d'actionnement déplaçant l'élément d'ajustement pour régler la force de pression correspondant à un état dans lequel le piston prend la position de détection de pression,
dans lequel
l'élément d'actionnement est prévu sur la paroi d'affichage de pression dotée de la partie de fenêtre.

2. Manocontacteur (10, 50) selon la revendication 1,
dans lequel la surface inclinée côté entraînement est formée de manière à être orientée dans une direction opposée à la paroi d'affichage de pression, et l'élément d'ajustement est mobile dans une direction s'écartant de la paroi d'affichage de pression, en déplaçant de cette manière l'élément de pression en direction du piston.

3. Manocontacteur (40) selon la revendication 1,
dans lequel la surface inclinée côté entraînement de l'élément d'ajustement est formée de manière à être orientée dans une direction de la paroi d'affichage de pression, et l'élément d'ajustement est mobile en direction de la paroi d'affichage de pression, en déplaçant de cette manière l'élément de pression en direction du piston.

4. Manocontacteur (10, 40) selon l'une quelconque des revendications 1 à 3,
dans lequel sur la paroi d'affichage de pression, une partie où une partie d'actionnement de l'élément d'actionnement est prévue et une partie où la partie de fenêtre est prévue sont sur le même plan.

5. Manocontacteur (50, 60) selon l'une quelconque des revendications 1 à 3,
dans lequel sur la paroi d'affichage de pression, une partie où une partie d'actionnement de l'élément d'actionnement est prévue et une partie où la partie de fenêtre est prévue sont décalées dans une direction de déplacement de l'élément d'ajustement.
